Europäisches Patentamt

European Patent Office

Office européen des brevets

(19)

(11) Numéro de publication : **0 526 265 A1**

(12) # DEMANDE DE BREVET EUROPEEN

(21) Numéro de dépôt : **92401704.9**

(22) Date de dépôt : **18.06.92**

(51) Int. Cl.⁵ : **H01L 31/0352**

(30) Priorité : **05.07.91 FR 9108451**

(43) Date de publication de la demande :
**03.02.93 Bulletin 93/05**

(84) Etats contractants désignés :
**DE GB**

(71) Demandeur : **THOMSON-CSF**
**51, Esplanade du Général de Gaulle**
**F-92800 Puteaux (FR)**

(72) Inventeur : **Rosencher, Emmanuel**
**THOMSON-CSF, SCPI, Cédex 67**
**F-92045 Paris la Défense (FR)**
Inventeur : **Bois, Philippe**
**THOMSON-CSF, SCPI, Cédex 67**
**F-92045 Paris la Défense (FR)**

(74) Mandataire : **Guérin, Michel et al**
**THOMSON-CSF SCPI B.P. 329**
**F-92402 COURBEVOIE CEDEX (FR)**

(54) **Détecteur d'ondes électromagnétiques.**

(57)    L'invention concerne un détecteur d'ondes électromagnétiques comportant un empilement de puits quantiques compris entre un contact ohmique et une jonction redresseuse qui peut être une barrière ($Al_yGa_{1-y}As$) de largeur de bande interdite plus élevée que celle des barrières du puits quantique.
Applications : Détection des rayonnements électromagnétiques.

FIG. 5

EP 0 526 265 A1

L'invention concerne un détecteur d'ondes électromagnétiques et notamment un détecteur en matériaux semiconducteurs à puits quantiques.

On connaît les détecteurs de radiations infrarouges à puits quantiques utilisant les transitions entre niveaux liés et niveaux libres d'une part et entre niveaux liés d'autre part. On rappelle brièvement leur mode de fonctionnement

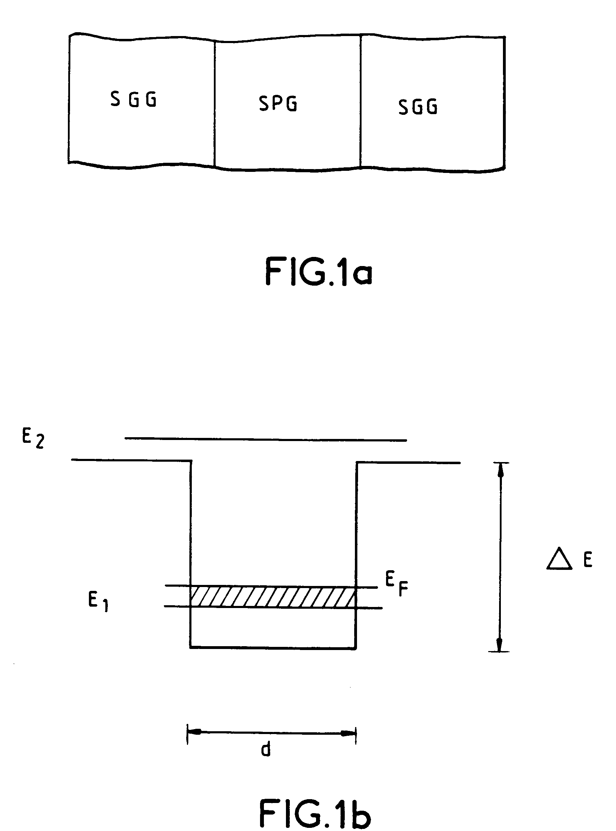

Il s'agit d'un empilement de couches alternées d'un semiconducteur à petit gap (SPG) entre deux semiconducteurs à grand gap (SGG) (comme représenté en figure la). L'écart énergétique entre les bas de bande de conduction des deux semiconducteurs est le "band-offset" $\Delta E$. Par exemple, ces deux semiconducteurs peuvent être en GaAs pour SPG et $Al_xGa_{1-x}A_s$ (où x varie entre 0 et 1) pour SGG. Les électrons dans une telle structure sont soumis à un puits de potentiel de profondeur $\Delta E$ et de largeur d, où d est la largeur de la couche du SPG. Si la largeur d est suffisamment petite, l'énergie des électrons correspondant au mouvement perpendiculaire aux couches est quantifiée en niveaux $E_1$, $E_2$.... Dans les détecteurs photoconductifs liés-libres, le niveau $E_1$ est lié ($E_1 < \Delta E$) et le niveau $E_2$ est libre ($E_2 \Delta E$). Si le niveau $E_1$ est occupé par un électron (par dopage par exemple), un photon d'énergie $h\nu$ supérieure à $\Delta E - E_1$ provoque une transition optique. L'électron est alors libre de se déplacer et peut être détecté comme un courant aux bornes des multipuits (voir figure 1b).

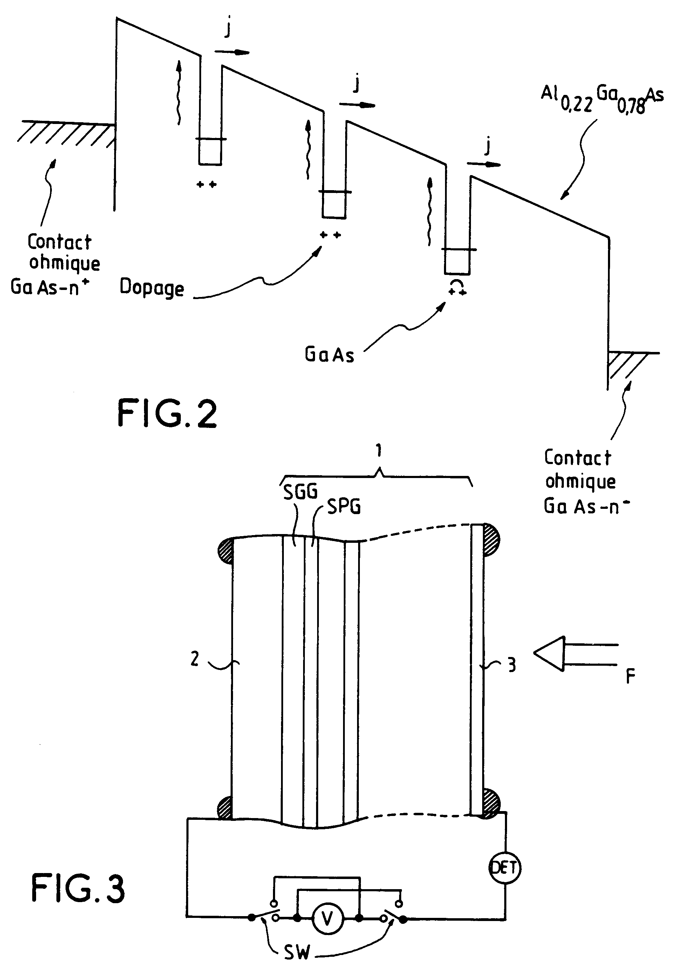

La structure détectrice est alors représentée en figure 2. Elle comporte un empilement de couches SGG/SPG/SGG dopées pris en sandwich entre 2 couches épaisses et très dopées de SPG assurant le contact ohmique. Le dispositif est à une température suffisamment faible pour que tous les électrons soient piégés dans les puits quantiques. Ce courant est donné par la relation :

$$J_{th} = J_{tho} e^{-[(\Delta E - E_1) - E_F]/kT} \quad (1)$$

où
- T est la température,
- k la constante de Boltzmann,
- $E_F$ est le niveau de Fermi des électrons dans les puits quantiques,
- $J_{tho}$ est le courant thermoionique donné par le document K. Brennan and Y. Wang : "Analysis of the two-dimensional dark currents in quantum well devices ", Appl. Phys. Lett. 57, 1337 (1990).

La réponse de ce photoconducteur est donnée par le raisonnement suivant. La densité volumique de porteurs est déterminée par le bilan entre la génération optique d'une part :

$$G = \eta . \phi / t$$

où $\eta$ est le rendement quantique, $\phi$ le flux de photons et t l'épaisseur du dispositif et la recombinaison d'autre part :

$$R = n/\tau$$

où n est la densité volumique d'électrons dans la bande de conduction du SGG et $\tau$ est la durée de vie de cet électron. La densité d'électrons photoexcités n est donné par G = R soit

$$n = \eta\tau\phi / t$$

et la densité de courant par :

$$j = n q \mu E$$
$$j = q\eta \tau \phi \mu E/t \quad (2)$$

où $\mu$ est la mobilité des électrons dans le SGG et E est le champ électrique appliqué. La réponse R de la structure est donnée par :

$$R = j/\phi h\nu = q \eta \tau \mu E/t h\nu$$

On constate qu'à champ électrique constant, cette réponse est indépendante du nombre de puits en régime stationnaire. L'invention concerne un dispositif dans lequel la réponse est croissante lorsque le nombre de puits augmente. La réponse est alors augmentée, ce qui augmente la détectivité.

L'invention concerne donc un détecteur d'ondes électromagnétiques comprenant un empilement de couches de matériaux différents présentant des largeurs de bandes interdites différentes, de façon à constituer un empilement de puits quantiques, caractérisé en ce que l'empilement de couches est compris entre un contact ohmique et une jonction redresseuse.

Les différents objets et caractéristiques de l'invention apparaîtront dans la description qui va suivre et dans les figures annexées qui représentent :
- les figures 1a, 1b et 2, des dispositifs de détection connus dans la technique ;
- la figure 3, un exemple général de réalisation d'un dispositif selon l'invention ;
- la figure 4, un exemple de réalisation détaillé d'un dispositif selon l'invention ;
- la figure 5, une variante de réalisation d'un dispositif selon l'invention ;
- les figures 6a à 6c, des diagrammes d'énergie explicatifs du fonctionnement du dispositif selon l'invention ;
- les figures 7 et 8, un fonctionnement en niveaux lié/lié du dispositif selon l'invention.

On prévoit donc une structure représentée en figure 3 comportant un empilement de puits quantiques 1 constitués de couches en semiconducteur à grand gap (SGG) et de couches à semiconducteur à petit gap (SPG) tel que :

$$\Delta E - E_1 = h\nu$$

où :

$\Delta E$ est l'écart énergétique entre les bas de bande de conduction des deux matériaux

$E_1$ est la valeur de l'énergie du premier permis des couches SPG

$h\nu$ est l'énergie d'un photon à détecter.

L'empilement de puits quantiques est muni d'un côté, d'une jonction redresseuse de courant 2 et de l'autre côté, d'un contact ohmique 3.

Un générateur de tension continue est connecté à la jonction 2 et au contact ohmique par un système d'inversion SW permettant d'inverser la tension appliquée.

Un détecteur DET placé en série avec le générateur de tension permet de détecter la circulation d'un courant.

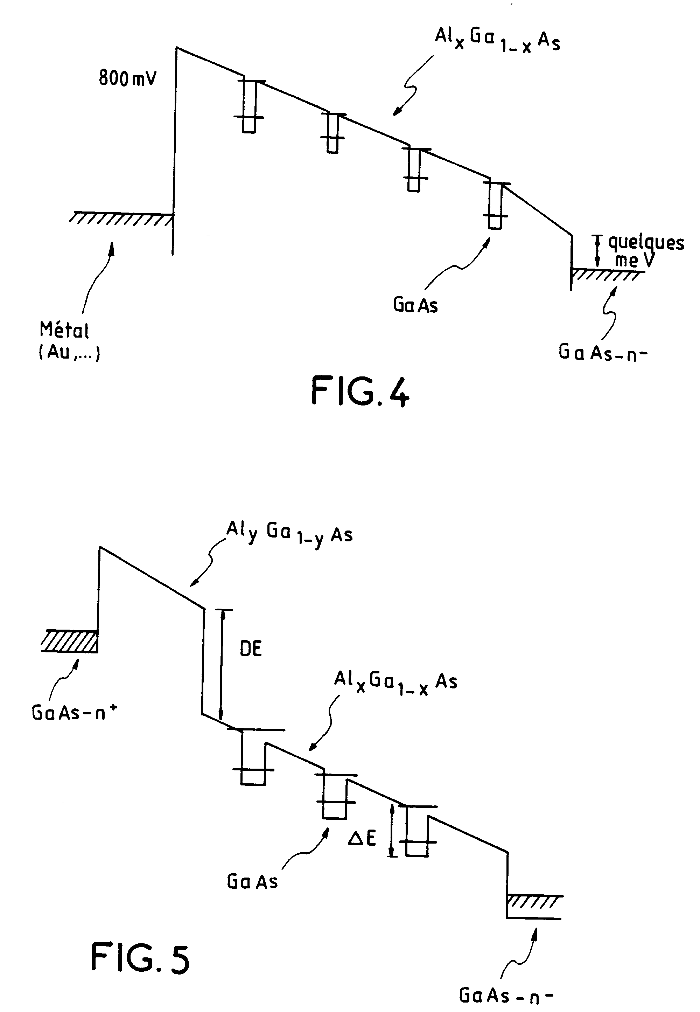

De façon plus détaillée, comme cela est représenté en figure 4, la structure selon l'invention peut être réalisée par exemple de la manière suivante :

- couches SPG (puits quantiques) en GaAs d'épaisseur environ d = 6nm ;
- couches SGG (barrières) en $Al_xGa_{1-x}As$ (avec x = 0,22 par exemple) d'épaisseur environ L = 30 nm ;

On a alors $\Delta E - E_1$ = 120 meV et l'on peut détecter des ondes de 10,6 $\mu$m de longueurs d'ondes.

Le contact ohmique est une couche de nature similaire à celle des couches SPG et est dopée n+. Il s'agit de GaAs-n+ dans l'exemple pris.

La jonction redresseuse peut être une barrière du type SCHOTTKY ce qui donne une structure suivante :

Métal/$Al_xGa_{1-x}As$/GaAs/$Al_xGa_{1-x}As$/...

/$Al_xGa_{1-x}As$/GaAs n+

La figure 5 représente une variante de réalisation dans laquelle la jonction redresseuse comporte une barrière dont la hauteur DE est nettement supérieure à $\Delta E$. Par exemple cette barrière peut être en $Al_yGa_{1-y}As$ avec y supérieur à x prévu dans la composition des barrières $Al_xGa_{1-x}As$. La structure a donc la configuration suivante :

GaAs-n+/$Al_yGa_{1-y}As$/$Al_xGa_{1-x}As$/GaAs/... /GaAs-n+

Dans ce qui va suivre nous explicitons le deuxième type de structure et nous considérons à titre d'exemple que y = 0,4.

Dans cette structure, le courant statique $J_f$ est dominé par la jonction GaAs-n+/$Al_{0.40}Ga_{0.6}As$ qui a une hauteur de barrière DE >> $\Delta E$. Ce courant est donné par la relation :

$$J_f = A * T^2 e^{-q.DE/kT}$$

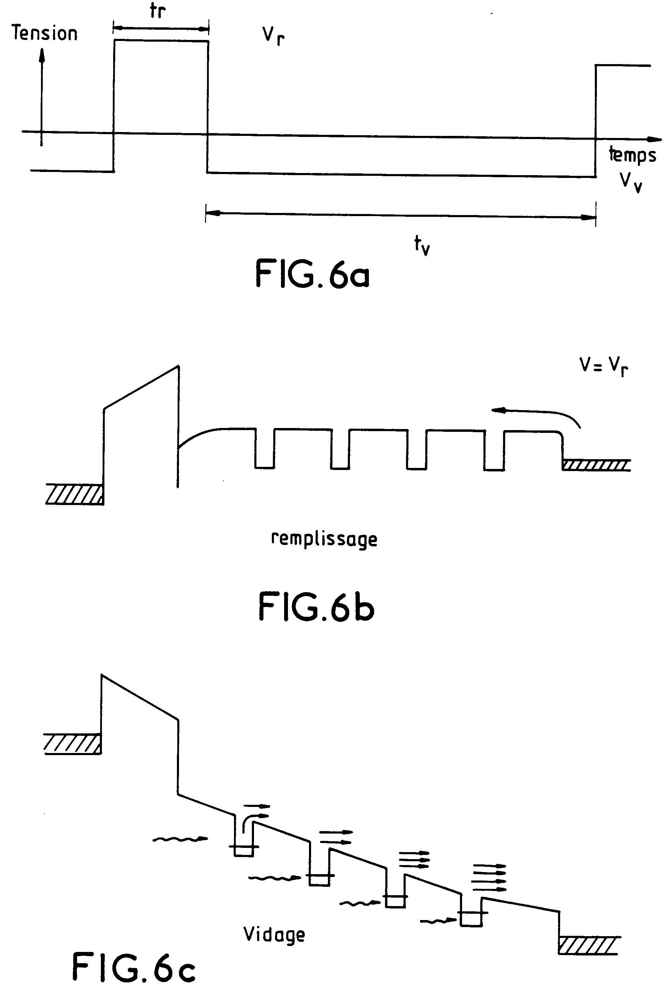

où A* = Constante de Richardson. Comme DE > $\Delta E$, on voit qu'à température égale le courant statique est beaucoup plus faible dans cette structure que dans les structures connues. Cette structure est alors soumise à des impulsions de potentiel comme représenté en figure 6a. Pendant un temps $t_R$, on applique une polarisation $V_R$ qui est telle que les puits quantiques sont remplis par le contact ohmique. Pendant un temps $t_v$, on applique une polarisation inverse. Si aucun photon n'est incident, la structure est dominée par l'émission thermique des électrons. Ce taux d'émission $e_n$ est donné par 5.

$$e_n = \sigma.v_{th}.N_c e^{-[(\Delta E - E_1) - E_F]/kT}$$

où :

$\sigma$ est la section efficace de capture,

$v_{th}$ la vitesse thermique des porteurs,

$N_c$ la densité effective dans .la bande de conduction de $Al_xGa_{1-x}As$.

On peut relier approximativement $e_n$ de cette équation au courant $J_{th}$ de l'équation (1) par la relation :

$$J_{th} = n_o.q.e_n$$

où $n_o$ est le dopage du puits.

Il est donc important de constater que les conditions pour avoir un courant d'obscurité faible dans un photoconducteur sont très voisines de celles pour avoir une constante de temps grande pour l'émission thermique. Par exemple, si l'on veut utiliser la structure selon l'invention pour une détection vidéo ($e_n < 24$ s$^{-1}$), alors

$$J_{th} = <. 10^{12} \times 10^{-19} \times 24 \times 1.6$$

$$\text{soit } J_{th} < 3.6 \times 10^{-6} \text{ A/cm}^2$$

Le nombre d'électrons n(t) dans chaque puits sous éclairement est donné par l'équation :

$$dn(t)/dt = -\sigma_{op}.n(t) \phi$$

où $\sigma_{op}$ est la section efficace optique du puits. Alors

$$n(t) = n_o e^{-\sigma_{op.\phi t}}$$

et la quantité de charges détectée est alors, si on admet que tous les électrons photoémis sont détectés :

$$Q(t) = q N n_o (1 - e^{-\sigma_{op\phi t}})$$

N est le nombre de puits quantiques. Le courant détecté est alors :

$$i_T(t) \;=\; q\,N\,n_o\,\sigma_{op}\,\phi e_{op\phi t}^{-\sigma}$$

Le signal détecté est donc proportionnel au nombre de puits quantiques contrairement au cas photodétecteur.

A titre d'exemple, les valeurs typiques de section efficace optique sont de $5 \times 10^{-15}$ cm$^2$. Pour des temps de lecture de 1/24 seconde, la réponse reste linéaire pour $\sigma_{op}.\ \phi < 24$ soit $\phi < 5.\ 10^{15}$ photons.cm$^{-2}$ ce qui est très important (environ 50 $\mu$w pour des photons de 100 meV).

Dans ce cas

$$i_T \;=\; q\,N\,n_o\,\sigma\,op\,\phi \quad (3)$$

On rappelle que dans les dispositifs connus, le courant photoconducteur est donné par l'équation (2).

Si on compare le courant $i_T$ au courant J de l'équation (2), on démontre que

$$i_T/J \;=\; t/\tau\,\mu E \;=\; t/\lambda$$

Ceci est l'inverse du gain de photoconduction. Pour une épaisseur $t = 5\ \mu$m, un produit $\mu\tau$ de $2.10^{-9}$ V.cm$^{-2}$ et $E = 10^4$ V/cm, ce gain inverse est de 25. Un tel gain permettra de faire fonctionner le dispositif a de plus hautes températures.

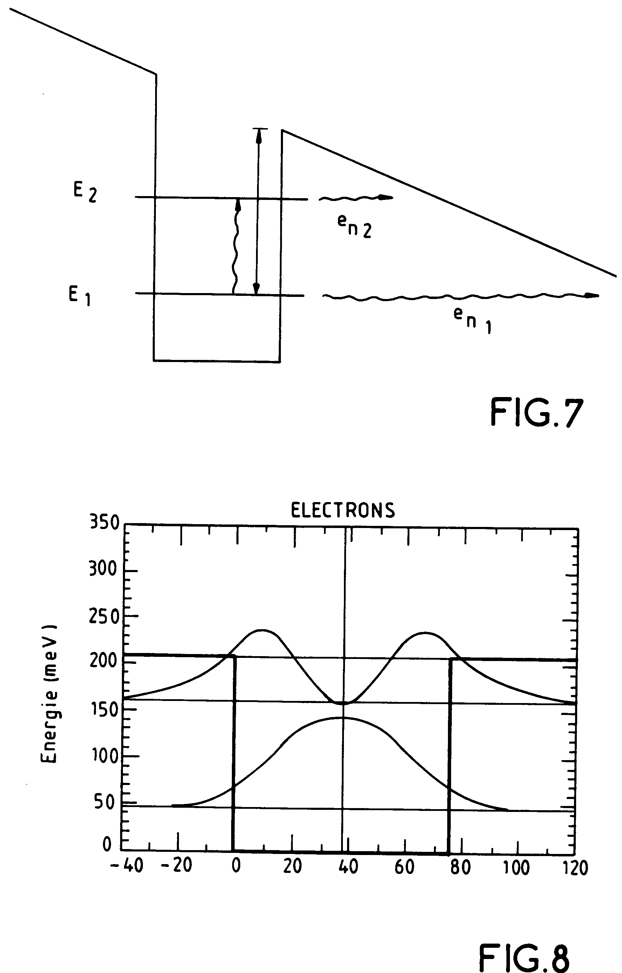

Une autre configuration de ce composant à l'électrode bloquante est de l'utiliser pour des transitions liées-liées, c'est-à-dire lorsque le niveau $E_2$ est à l'intérieur du puits (figure 7). On sait qu'on est alors obligé, dans les photoconducteurs quantiques de rapprocher les puits suffisamment pour permettre la conduction tunnel d'un puits à l'autre, ce qui augmente le courant d'obscurité et donc détériore la détectivité. Dans le fonctionnement transitoire par électrode bloquante, la condition par effet tunnel entre puits peut être évitée. Il suffit cette fois que la probabilité d'émission par effet tunnel hors du puits soit suffisamment élevée pour court-circuiter la recombinaison entre sous - bandes. Ce temps est de l'ordre de 10 picosecondes, il suffit donc d'appliquer un champ électrique tel que le temps tunnel sur le deuxième niveau soit inférieur à 10 ps.

Deux conditions doivent donc être respectées :

Condition 1 : $\quad e_{FN}\,(\Delta E) < 24$ s$^{-1}$

Condition 2 : $\quad e_{FN}\,(\Delta E - h) > 10^{11}$s$^{-1}$

$e_{FN}$ est le taux d'émission par tunnel assisté par le champ électrique ou effet Fowler-Nordheim.

La condition 1 veut dire que le taux d'émission est bien plus faible que la fréquence vidéo et la condition 2 assure que, néanmoins, l'électron sur l'état excité sortira du puits ayant de se recombiner sur le niveau fondamental. Un exemple remplissant ces deux conditions est donné en figure 8.

Dans cet exemple, le pourcentage en Aluminium dans la barrière est d'environ 25 %.

Taille du puits : 7, 5 nm

Ce puits absorbe à 10.6 $\mu$m et peut fonctionner jusqu'à 100 K.

Les circuits de polarisation et de lecture de tels dispositifs impulsionnels seraient équivalents aux circuits utilisés de l'art dans les détecteurs Si:Ga à bande d'impuretés bloquées.

Il est bien évident que la description qui précède n'a été faite qu'à titre d'exemple non limitatif et que d'autres variantes peuvent être envisagées sans sortir du cadre de l'invention. Notamment les compositions des couches de matériaux et leurs épaisseurs peuvent être différentes de celles indiquées dans ce qui précède.

## Revendications

1. Détecteur d'ondes électromagnétiques comprenant un empilement de couches de matériaux différents présentant des largeurs de bandes interdites différentes, de façon à constituer un empilement de puits quantiques, caractérisé en ce que l'empilement de couches est compris entre un contact ohmique et une jonction redresseuse.

2. Détecteur selon la revendication 1, caractérisé en ce que la jonction redresseuse comporte une diode Shottky.

3. Détecteur selon la revendication 1, caractérisé en ce que la jonction redresseuse comporte une barrière de largeur de bande interdite nettement plus élevée que celle des barrières des puits quantiques.

4. Détecteur selon la revendication 1, caractérisé en ce qu'il comporte des moyens d'application d'une tension directe et d'une tension inverse connectés d'une part au contact ohmique, d'autre part à la jonction redresseuse.

5. Détecteur selon la revendication 3, caractérisé en ce que la barrière de la jonction redresseuse est en un matériau comportant les mêmes constituants que celui des barrières des puits quantiques mais en composition différente.

6. Détecteur selon la revendication 1, caractérisé en ce que l'empilement de puits est un empilement de couches :

$$Al_xGa_{1-x}As/GaAs/Al_xGa_{1-x}As$$

7. Détecteur selon la revendication 6, caractérisé en ce que la barrière de la jonction redresseuse est de type $Al_yGa_{1-y}Al$ avec y supérieur à x.

FIG.1a

FIG.1b

FIG.2

FIG.3

FIG.4

FIG.5

Tension

tr

$V_r$

temps

$V_v$

$t_v$

## FIG.6a

$V = V_r$

remplissage

## FIG.6b

Vidage

## FIG.6c

FIG.7

FIG.8

**Office européen des brevets**

# RAPPORT DE RECHERCHE EUROPEENNE

Numero de la demande

EP 92 40 1704

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | APPLIED PHYSICS LETTERS vol. 45, no. 6, 15 septembre 1984, pages 649-651, New York, US; D.D. COON et al.: "New mode of IR detection using quantum wells" * le document en entier * | 1-7 | H 01 L 31/0352 |
| X | FR-A-2 627 013 (THOMSON-CSF) * revendications 1-10; figures 1,2 * | 1 | |
| X | JAPANESE JOURNAL OF APPLIED PHYSICS vol. 27, no. 12, décembre 1988, pages L2434-L2437, Tokyo, JP; Y.L. JIANG et al.: "Field-Drifting Resonance Tunneling Through a-Si:H/a-SiC:H Double Barrier in the p-i-n Structure" * le document en entier * | 1 | |
| A | APPLIED PHYSICS LETTERS vol. 50, no. 16, 20 avril 1987, pages 1092-1094, New York, US; B.F. LEVINE et al.: "New 10 micrometer infrared detector using intersubband absorption in resonant tunneling GaAlAs superlattices" * le document en entier * | 1-7 | DOMAINES TECHNIQUES RECHERCHES (Int. Cl.5) H 01 L |
| A | ELECTRONICS LETTERS vol. 25, 22 novembre 1989, pages S70-S72, Stevenage, GB; B.F. LEVINE et al.: "GaAs/AlGaAs quantum-well, long-wavelength infra-red (LWIR) detector with a detectivity comparable to HgCdTe" * le document en entier * | 1-7 | |

Le présent rapport a été établi pour toutes les revendications

| Lieu de la recherche | Date d'achèvement de la recherche | Examinateur |
|---|---|---|
| BERLIN | 16-10-1992 | MUNNIX S J G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P0402)